# EUROPEAN PATENT APPLICATION

(11) **EP 2 503 604 A1**
(43) Date of publication of application: **26.09.2012**
(21) Application number: 10831129.1
(22) Date of filing: 17.11.2010
(51) Int. Cl.: H01L 33/32, H01L 25/075

(54) **LED LIGHT EMITTING MODULE AND MANUFACTURING METHOD THEREOF**

(30) Priority: 18.11.2009 CN 200910194132
(71) Applicant: Zhuhai Suntac Optoelectronic Co., Ltd., Zhuhai, Guangdong 519085 (CN)
(72) Inventor: JIN, Baoyu, Guangdong 519085 (CN); YANG, Gang, Guangdong 519085 (CN)
(74) Representative: Hellmich, Wolfgang
(86) International application number: PCT/CN2010/078810
(87) International publication number: WO 2011/060714

(57) **Abstract**

An LED light-emitting module and a manufacturing method thereof are provided. The LED light-emitting module comprises a substrate provided with at least one LED core, wherein the substrate has an interlayer made of ceramic materials and coated with copper foils at two sides; the copper foil at one side of the interlayer is etched to form at least one soldering pad and a conductor; the number of the soldering pads is equal to that of the LED cores; each LED core is fixed on one soldering pad; and one pole of the LED core is welded on the soldering pad while the other pole is connected with an adjacent soldering pad or the conductor through a gold thread.

## Description

### FIELD OF THE INVENTION

The invention relates to an LED light source for illumination, in particular to an LED light-emitting module manufactured on a ceramic substrate coated with copper foils at two sides and a manufacturing method thereof. The invention is based on the Chinese invention patent application No. 200910194132.1 filed on Nov. 18, 2009, and the content of the application is cited in the text as a reference document closely related to the invention.

### BACKGROUND OF THE INVENTION

The LED light-emitting module is used as a novel lighting source, has the advantages of energy saving, environmental protection, long service life, low energy consumption, etc., and has been widely applied in the fields of household lighting, commercial lighting, road lighting, industrial and mineral lighting and the like.

The available LED light-emitting modules are mostly provided with substrates made of aluminum matrix materials, wherein one or more LED chips are welded on the substrate. As the LED light source is a cold light source and the core light-emitting part thereof is a PN junction, a large amount of heat is generated when fluorescent powder is excited to emit light by photons of the LED core. If the heat cannot be conducted away in time, the aging speed of the fluorescent powder can be accelerated and the service life of the LED core can be shortened, which is the bottleneck of the service life of the available LED light source.

The Chinese invention patent application No. CN101483217A discloses an invention titled "High Thermal Conductivity Ceramic Copper-Clad Cooling LED Circuit Board" aiming at solving the problems, wherein a substrate of the circuit board is a ceramic plate; copper foils are coated at two sides of the ceramic plate; a copper-aluminum spinel eutectic interface is respectively arranged between the copper foils and the ceramic plate; and lines formed by the copper foils at two sides of the ceramic plate are connected and communicated with each other via through holes formed by sintering.

The copper foils at two sides of the ceramic plate are all one part of the lines for the circuit board. As the through holes are reserved on the ceramic plate to connect partial lines at two sides of the ceramic plate, the good insulating property of the ceramic plate as an insulating material cannot be given full play. Moreover, when the circuit board is manufactured, the through holes are required to be processed on the ceramic plate by laser, so the processing techniques of the circuit board are complicated, thus the cost of the LED light-emitting module is increased.

Moreover, due to the unevenly distributed lines on the ceramic plate, the ceramic plate tends to be deformed because of uneven heat distribution, thus the service life of the LED light-emitting module is affected.

### SUMMARY OF THE INVENTION

The main objective of the invention is to provide an LED light-emitting module with good heat dissipation performance.

Another objective of the invention is to provide an LED light-emitting module with low production cost.

Another objective of the invention is to provide a simple method for manufacturing the LED light-emitting module.

In order to achieve the main objective, the LED light-emitting module provided by the invention comprises a substrate, wherein one or more LED cores are arranged on the substrate; the substrate is a ceramic plate coated with copper foils at two sides, namely having an interlayer made of ceramic materials; the copper foils are coated at two sides of the interlayer; the copper foil at one side of the interlayer is etched to form at least one soldering pad and a conductor; the number of the soldering pads is equal to that of the LED cores; each LED core is fixed on one soldering pad; and one pole of the LED core is welded on the soldering pad while the other pole of the LED core is connected with an adjacent soldering pad or the conductor through a gold thread.

It can be seen from the proposal that: as the LED core is fixed on the soldering pad, the heat generated can be quickly diffused transversely through the soldering pad and conducted to the interlayer, and then received by the copper foil at the other side of the interlayer and conducted to a radiator connected with the copper foil, thus the heat generated by the LED core can be quickly conducted away. Consequently the service life of the LED light-emitting module can be prolonged.

Moreover, the LED core is welded on the copper foil at one side of the interlayer and no through hole is required to be reserved on the ceramic plate coated with the copper foils at two sides when the LED light-emitting module is manufactured. Thus the processing techniques of the LED light-emitting module are simple and the production cost of the LED light-emitting module is reduced.

A preferred proposal is as follows: the area of each soldering pad is more than three times that of the LED core fixed on the soldering pad. Therefore, the area of the soldering area is far more than that of the LED core, thus the heat generated by the LED core can be quickly diffused and overhigh temperature on the periphery of the LED core is avoided, consequently the heat dissipation performance is good.

In order to achieve the another objective, the method for manufacturing the LED light-emitting module provided by the invention comprises the following steps of: forming at least one soldering pad and a conductor on a copper foil at one side of a ceramic plate coated with copper foils at two sides by etching; and fixing one LED core on each soldering pad, wherein one pole of the LED core is welded on the soldering pad and a gold thread is subjected to spot welding between the other pole of the LED core and the conductor or a soldering pad adjacent to the soldering pad on which the LED core is welded.

In this way, no through hole is required to be reserved on the ceramic plate coated with the copper foils at two sides when the LED light-emitting module is manufactured, thus the production cost of the LED light-emitting module is reduced. Moreover, as the lines such as the soldering pads and the conductor are evenly distributed at one side of the ceramic plate, the insulating property of the ceramic plate can be given full play, thus the electrical connection between the copper foils at two sides of the ceramic plate can be cut off.

### BRIEF DESCRIPTION OF THE DRAWINGS

Fig. 1 is a structure diagram of a first embodiment of the LED light-emitting module provided by the invention;

Fig. 2 is a diminished structure diagram, seen from another angle of view, of the first embodiment of the LED light-emitting module provided by the invention;

Fig. 3 is a partial sectional enlarged view of the first embodiment of the LED light-emitting module provided by the invention; and

Fig. 4 is a structure diagram of a second embodiment of the LED light-emitting module provided by the invention.

Further description is given to the invention with the attached embodiments and drawings.

### DETAILED DESCRIPTION OF THE PREFERRED EMBODIMENTS

First embodiment of the LED light-emitting module:

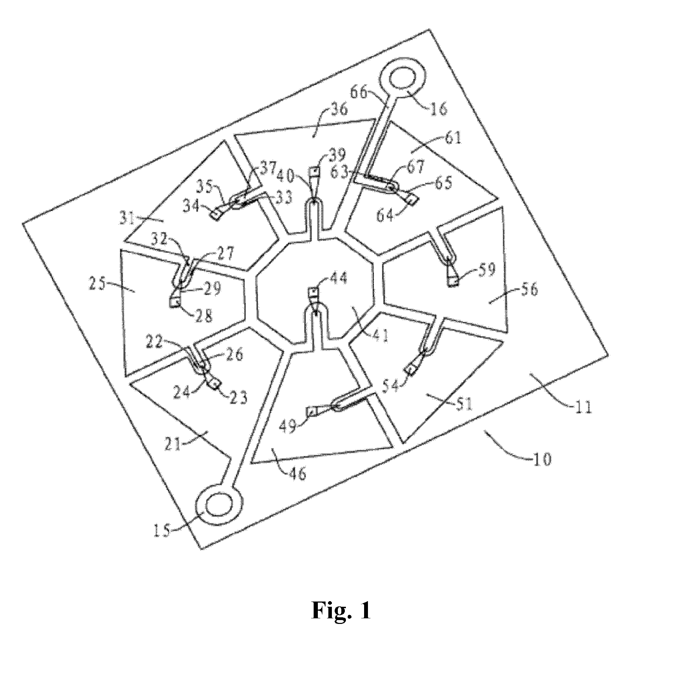

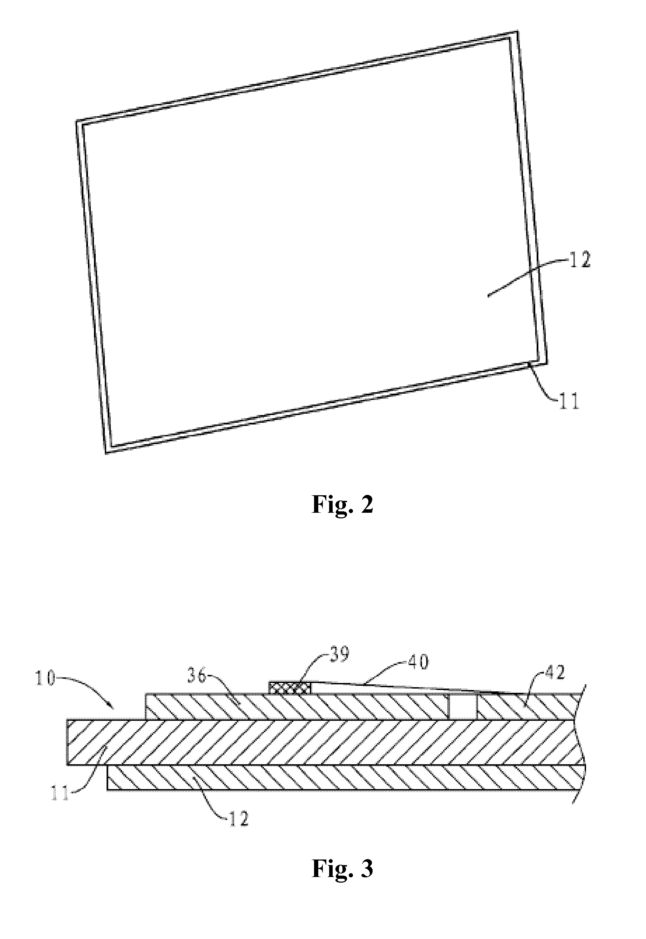

As illustrated in Figs. 1 and 2, the embodiment comprises a substrate 10, wherein the substrate 10 is a ceramic plate coated with copper foils at two sides (DBC Direct Bonded Copper), which has an interlayer 11 made of ceramic materials with high thermal conductivity; and the copper foils are evenly coated at two sides of the interlayer 11 and almost distributed on the whole surface of the interlayer 11. As illustrated in Fig. 2, as the copper foil 12 at the rear of the interlayer 11 is not subjected to etching treatment, the copper foil 12 at the rear of the interlayer 11 is almost distributed on the whole surface of the interlayer 11.

The copper foil on the front of the substrate 10 is etched to form lines for the LED light-emitting module; the lines comprise nine soldering pads 21, 25, 31, 36, 41, 46, 51, 56 and 61 and a conductor 66; a positive terminal 15 connected with the soldering pad 21 is arranged outside the soldering pad 21; and the conductor 66 is connected with a negative terminal 16.

In the embodiment, the soldering pads 21, 25, 31, 36, 46, 51, 56 and 61 are evenly distributed on the interlayer 11 to form a regular octagon; each soldering pad among the eight soldering pads is approximately in the shape of a trapezoid; and an octagonal gap is formed in the middle of the interlayer 11 by the eight soldering pads. The soldering pad 41 is arranged inside the gap in the middle of the eight soldering pads and is approximately in the shape of a trapezoid, and the area of the soldering pad 41 is slightly less than that of the gap. Preferably, the area of and the space among the nine soldering pads is equal to each other, so that the area of the interlayer 11 can be given full play. Moreover, the area of the soldering pads is far more than that of the conductor 66, thus the problem that the heat dissipation of the LED cores is affected by the overlarge area of the conductor 66 is avoided.

An LED core 23 is welded on the soldering pad 21. Preferably, the LED core 23 is connected to the soldering pad 21 by direct bonding, and an anode of the LED core 23 is welded on the soldering pad 21. That is to say, solder such as silver paste is placed in the center of the soldering pad 21; the LED core 23 is placed on the solder; copper atoms of the soldering pad 21 are enabled to be fused with silver atoms in the solder at certain temperature; and simultaneously metal atoms of the LED core 23 are enabled to be fused with the silver atoms in the solder, thus the objective of fixing the LED core 23 on the soldering pad 21 is achieved.

An inward concave portion 22 is arranged on an edge of the soldering pad 21, opposite to the adjacent soldering pad 25, and an extended portion 26 extended into the concave portion 22 is arranged on an edge of the soldering pad 25, opposite to the soldering pad 21. Moreover, the soldering pads 21 and 26 are not directly electrically connected with each other.

A cathode of the LED core 23 is connected with a gold thread 24 of which the other end is connected to the extended portion 26 of the soldering pad 25, thus the anode of the LED core 23 is electrically connected with the soldering pad 21 while the cathode of the LED core 23 is electrically connected with the soldering pad 25, namely the soldering pads 21 and 25 are connected with each other in series through the LED core 23.

As illustrated in Fig. 1, the area of the soldering pad 21 is far more than that of the LED core 23. Preferably, the area of the soldering pad 21 is more than three times that of the LED core 23, and the LED core 23 is arranged in the center of the soldering pad 21. Therefore, the heat generated by the LED core 23 can be quickly conducted to the soldering pad 21 and then can be quickly diffused transversely along the soldering pad 21 due to the large area of the soldering pad 21, thus the problem of overhigh temperature of the LED core 23 caused by the fact that the heat is concentrated on the periphery of the LED core 23 is avoided, consequently the problem that the service life of the LED core 23 is affected by the too concentrated heat on the LED core 23 is avoided.

The other soldering pads 25, 31, 36, 41, 46, 51, 56 and 61 are adjacent to each other in turn; an LED core 28, 34, 39, 44, 49, 54, 59 or 64 is respectively arranged on each soldering pad; each LED core corresponds to one soldering pad; and an anode of the LED core is welded on the corresponding soldering pad.

A concave portion and an extended portion are arranged on all the soldering pads 25, 31, 36, 41, 46, 51, 56 and 61 respectively, and an extended portion is extended into a concave portion of an adjacent soldering pad. For example, an extended portion 26 of the soldering pad 25 is extended into a concave portion 22 of the soldering pad 21; an extended portion 32 of the soldering pad 31 is extended into a concave portion 27 of the soldering pad 25; an extended portion 37 of the soldering pad 36 is extended into a concave portion 33 of the soldering pad 31.

The anode of each LED core is welded on the corresponding soldering pad, and a cathode of the LED core is connected to an extended portion of an adjacent soldering pad through a gold thread. For example, a cathode of the LED core 28 is connected to an extended portion 32 of the soldering pad 31 through a gold thread 29; and a cathode of the LED core 34 is connected to an extended portion 37 of the soldering pad 36 through a gold thread 35. Moreover, the area of each soldering pad is far more than that of the LED core welded thereon, so as to be favorable for the heat dissipation of the LED core.

The conductor 66 is arranged between the soldering pads 36 and 61; the negative terminal 16 is arranged at the end of the conductor 66 and connected with a negative electrode of a power source; the conductor 66 is provided with an extended portion 67 which is extended into the concave portion 63 of the soldering pad 61; the LED core 64 is welded in the center of the soldering pad 61; and an anode of the LED core 64 is welded on the soldering pad 61 while a cathode of the LED core 64 is connected to the extended portion 67 of the conductor 66 through a gold thread 65.

Obviously, the nine LED cores of the LED light-emitting module are connected with each other in series in turn. After the power source of the LED light-emitting module is turned on, direct current flows into the soldering pad 21 from the positive terminal 15, flows across the LED cores 23, 28, 34, 39, 44, 49, 54, 59 and 64 in turn, flows across the conductor 66, and flows out of the negative terminal 16.

In the embodiment, eight LED cores among the nine LED cores, namely the LED cores 23, 28, 34, 39, 49, 54, 59 and 64 are positioned on the same circle and evenly distributed on the circle. Meanwhile, an LED core 44 is positioned in the center of the circle. Therefore, the nine LED cores are evenly distributed on the substrate 10 and the space among the LED cores is equal to each other, so as to be favorable for the heat dissipation of the LED cores.

As illustrated in Fig. 3, the thickness of the copper foils at two sides of the interlayer 11 of the substrate 10 is about 0.3 to 0.5 mm, and is preferably equal to each other. The copper foil on the front of the interlayer 11 is etched to form the soldering pads and the conductor; an LED core 39 is welded on the soldering pad 36; and a cathode of the LED core 39 is connected to the soldering pad 41 adjacent to the soldering pad 36 through a gold thread 40.

The heat generated by the LED core 39 during the light emitting is settled on the soldering pad 36. As the area of the soldering pad 36 is far more than that of the LED core 39, the heat can be quickly diffused on the soldering pad 36. Moreover, as the nine soldering pads are evenly distributed on the front of the interlayer 11, the ceramic plate as the interlayer 11 is evenly heated, thus the problem that the ceramic plate is deformed due to uneven heating is avoided. After the ceramic plate is heated, the heat is conducted to the copper foil 12 at the rear of the interlayer 11, conducted to the radiator connected therewith through the copper foil 12, and diffused by the radiator.

In the embodiment, the LED cores, the soldering pads and the conductor are evenly arranged on the front of the substrate 10. Therefore, the electrical isolation of the copper foils at two sides of the ceramic plate, as the interlayer 11, of the substrate 10 is realized; the insulating property of the ceramic plate is given full play; the direct electrical connection between the radiator and the LED cores is avoided; and the electrical isolation between the LED light-emitting module and the radiator is realized.

An embodiment of the method for manufacturing the LED light-emitting module:

When the LED light-emitting module is manufactured, firstly, a ceramic plate coated with copper foils at two sides with proper area is selected; a proper circuit is designed, for example, the nine soldering pads and the conductor in the first embodiment, wherein the soldering pads are provided with the concave portions and the extended portions, and the extended portion of the conductor is extended into the concave portion of the adjacent soldering pad; and lines are formed on the front of the substrate 10 by etching according to the designed circuit.

Secondly, an LED core is connected to the center of each soldering pad by direct bonding, and an anode of each LED core is welded on the corresponding soldering pad. When the LED core is welded, silver paste or tin-base materials, with high conductivity, are taken as solder so that the heat generated by the LED core can be conducted to the soldering pad through the solder with high conductivity.

Thirdly, one end of a gold thread is welded on a cathode of the LED core while the other end of the gold thread is welded on an extended portion of a conductor or a soldering pad adjacent to the soldering pad on which the LED core is welded, so that the nine LED cores are connected with each other in series in turn.

After the above steps, encapsulating materials with high light transmittance such as epoxy resin can be filled into the LED cores to protect the gold threads from being damaged. And herein the manufacturing of the LED light-emitting module is completed.

Obviously, as no through hole is required to be arranged on the substrate 10 when the LED light-emitting module is manufactured, the processing techniques of the LED light-emitting module are simple, thus the production cost of the LED light-emitting module is reduced and the large-scale production of the LED light-emitting module is realized.

Second embodiment of the LED light-emitting module:

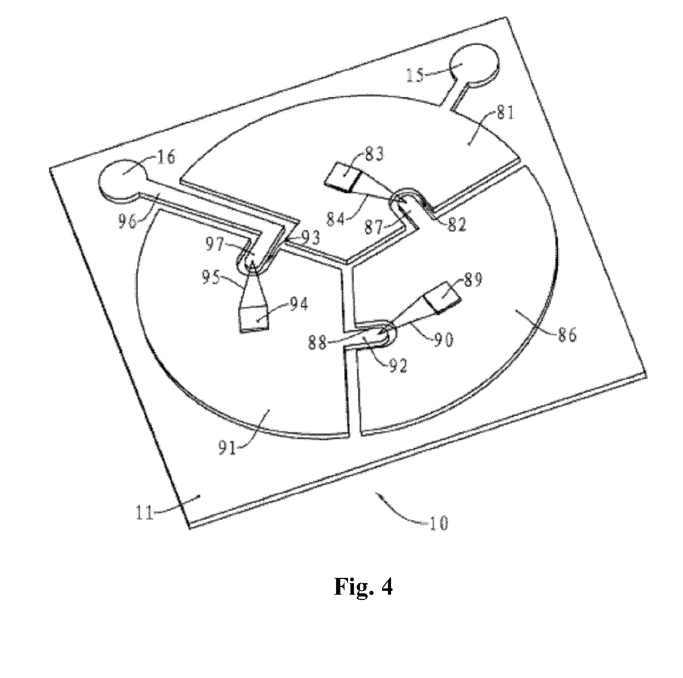

As illustrated in Fig. 4, the embodiment also comprises a substrate 10, wherein the substrate 10 is a ceramic plate coated with copper foils at two sides and has an interlayer 11; the copper foils are evenly coated at two sides of the interlayer 11; the copper foil at the rear is not subjected to etching treatment; the copper foil on the front of the substrate 10 is etched to form three soldering pads 81, 86 and 91 and a conductor 96; and the conductor 96 is arranged between the soldering pads 81 and 91.

In the embodiment, each soldering pad is approximately designed in the shape of a sector; the three soldering pads 81, 86 and 91 and the conductor 96 are approximately distributed in a circle; an LED core is welded in the center of each soldering pad; and three LED cores 83, 89 and 94 are arranged on the same circle and evenly distributed on the circle.

An outer edge of the soldering pad 81 is connected with a positive terminal 15; a concave portion 82 is arranged on an edge of the soldering pad 81, opposite to the soldering pad 86; the soldering pad 86 is provided with an extended portion 87 which is extended into the concave portion 82; and a cathode of the LED core 83 welded on the soldering pad 81 is connected with the extended portion 87 through a gold thread 84.

Similarly, the soldering pad 86 is also provided with a concave portion 88; the soldering pad 91 is also provided with an extended portion 92 which is extended into the concave portion 88; an anode of the LED core 89 is welded on the soldering pad 86; and a cathode of the LED core 89 is connected with the extended portion 92 through a gold thread 90.

The outer end of the conductor 96 is connected with a negative terminal 16 while the inner end of the conductor 96 is provided with an extended portion 97 which is extended into a concave portion 93 of the soldering pad 91; and a cathode of the LED core 94 welded on the soldering pad 91 is connected with the extended portion 97 through a gold thread 95.

In this way, the three LED cores are connected with each other in series in turn. Current flows into the soldering pad 81 from the positive terminal 15, flows across the LED cores 83, 89 and 94 in turn, flows across the conductor 96, and flows out of the negative terminal 16.

In the embodiment, the area of the soldering pads 81, 86 and 91 is far more than that of the LED cores 93, 89 and 94 welded thereon. Therefore, the heat generated by the LED cores 93, 89 and 94 can be quickly diffused transversely through the soldering pads and diffused longitudinally to the ceramic plate as the interlayer 11. Obviously, the heat generated by the LED cores 93, 89 and 94 can be quickly conducted away in the embodiment, thus the problem that the service life of the LED cores 93, 89 and 94 is affected by the overhigh junction temperature of the LED cores 93, 89 and 94 is avoided.

Moreover, the method for manufacturing the LED light-emitting module of the embodiment is the same with that of the first embodiment. As no through hole is required to be reserved on the substrate 10 during the processing, the processing techniques are simple and the production cost is low.

Of course, the embodiments are only preferred embodiments of the invention, and there are more variations during the actual application. For example, the welding positions of the anodes and the cathodes of the LED cores are reversed, namely the cathodes of the LED cores are welded on the soldering pads while the anodes of the LED cores are connected to the extended portions of the conductor or the soldering pads adjacent to the soldering pads on which the LED cores are welded; or only one soldering pad and one conductor are formed on the substrate by etching and one LED core is welded on the soldering pad. The variations can also achieve the objectives of the invention.

Finally, it should be noted that the invention is not limited to the above embodiments. Slight variations, such as the variation in the number of the LED cores, the variation in the distribution positions of the numerous LED cores on the substrate, the variation in the shape of the soldering pads, and the variation in the fixing means of the cores on the soldering pads, should also be within the scope of protection of the claims of the invention.

### Industrial Applicability

The heat generated by the LED cores of the LED light-emitting module provided by the invention can be quickly diffused transversely through the soldering pads and conducted to the interlayer, and then received by the copper foil at the other side of the interlayer and conducted to the radiator connected with the copper foil, so the heat generated by the LED cores can be conducted away quickly, thus the service life of the LED light-emitting module can be prolonged. When the LED light-emitting module is manufactured, no through hole is required to be reserved on the ceramic plate coated with the copper foils at two sides, thus the production cost of the LED light-emitting module is reduced. Moreover, as the lines such as the soldering pads and the conductor are evenly distributed at one side of the ceramic plate, the insulating property of the ceramic plate can be given full play, thus the electrical connection between the copper foils at two sides of the ceramic plate can be cut off.

## Claims

1. An LED light-emitting module, comprising a substrate, the substrate being arranged one or more LED cores; wherein the substrate is a ceramic plate coated with copper foils at two sides and has an interlayer made of ceramic materials; the copper foils are coated at two sides of the interlayer; the copper foil at one side of the interlayer etched to form at least one soldering pad and a conductor; the number of the soldering pads is equal to that of the LED cores; each LED core is fixed on one soldering pad; and one pole of the LED core is welded on the soldering pad while the other pole of the LED core connected with an adjacent soldering pad or the conductor through a gold thread.

2. The LED light-emitting module according to claim 1, wherein the area of the soldering pads is more than three times that of the LED cores bonded on the soldering pads.

3. The LED light-emitting module according to claim 1 or 2, wherein each soldering pad is provided with a concave portion; and the conductor is provided with an extended portion which is extended into a concave portion of an adjacent soldering pad.

4. The LED light-emitting module according to claim 1 or 2, wherein each LED core is directly bonded on the corresponding soldering pad by tin-base materials or silver paste; and an anode of the LED core is welded on the soldering pad while a cathode of the LED core is connected with the adjacent soldering pad or the conductor through the gold thread.

5. The LED light-emitting module according to claim 1 or 2, wherein each LED core is directly bonded on the corresponding soldering pad by tin-base materials or silver paste; and an anode of the LED core is connected with the adjacent soldering pad or the conductor through the gold thread while a cathode of the LED core is welded on the soldering pad.

6. A method for manufacturing the LED light-emitting module, comprising the following steps of:
forming at least one soldering pad and a conductor on a copper foil at one side of a ceramic plate coated with copper foils at two sides by etching; and
fixing one LED core on each soldering pad, wherein one pole of the LED core is connected to the soldering pad, and a gold thread is subjected to spot welding between the other pole of the LED core and the conductor or a soldering pad adjacent to the soldering pad on which the LED core is welded.

7. The method for manufacturing the LED light-emitting module according to claim 6, wherein the area of the soldering pad formed by etching is more than three times that of the LED core fixed on the soldering pad.

8. The method for manufacturing the LED light-emitting module according to claim 6 or 7, wherein the soldering pad formed by etching is provided with a concave portion; and the conductor is provided with an extended portion which is extended into a concave portion of an adjacent soldering pad.

9. The method for manufacturing the LED light-emitting module according to claim 6 or 7, wherein each LED core is directly bonded on the corresponding soldering pad by tin-base materials or silver paste.
